# EUROPÄISCHE PATENTANMELDUNG

(11) **EP 0 984 491 A1**
(43) Veröffentlichungstag der Anmeldung: **08.03.2000**
(21) Anmeldenummer: 99810664.5
(22) Anmeldetag: 23.07.1999
(51) Int. Cl.: H01L 23/00, H01L 23/16

(54) **Explosionsschutz für Halbleitermodule**

(30) Priorität: 29.08.1998 DE 19839422
(71) Anmelder: Asea Brown Boveri AG, 5401 Baden (CH)
(72) Erfinder: Lang, Thomas, Dr., 8051 Zürich (CH); Zeller, Hans-Rudolf, Dr., 5242 Birr (CH)
(74) Vertreter: Clerc, Natalia

(57) **Zusammenfassung**

Ein Hochleistungs-Halbleitermodul mit einem Gehäuse (2,2',2"), welches mindestens ein Halbleiterelement umschliesst, weist ein Explosionsschutzelement auf. Dieses Explosionsschutzelement ist eine mindestens einen Teil des Gehäuses (2,2',2'') umgebende Schutzhülle (5), welche Fragmente, die bei einer Explosion des Halbleiterelementes weggeschleudert werden, auffängt. Dadurch wird verhindert, dass durch derartige Fragmente Personen oder benachbarte Module zu Schaden kommen.

## Beschreibung

### TECHNISCHES GEBIET

Die vorliegende Erfindung bezieht sich auf das Gebiet der Leistungselektronik. Sie betrifft ein Hochleistungs-Halbleitermodul gemäss Oberbegriff des Patentanspruches 1.

### STAND DER TECHNIK

Bei heutigen Stromrichtern mit sehr kleiner Streuinduktivität und keiner Schutzschaltung entlädt sich im Falle eines Kurzschlusses die gesamte Energie eines Speicherkondensators in wenigen Mikrosekunden. Dabei treten Ströme im Bereich von einigen hundert Kilo-Ampère und Leistungen im Bereich von 100 MW auf. Ein Kurzschluss führt deshalb nicht selten zu einer Explosion, bei welcher Fragmente des Halbleiterelementes sowie des Gehäuses geschossähnlich weggeschleudert werden.

Bei der Planung von Modulen sind deshalb für den Fall einer Explosion folgende Auflagen zu berücksichtigen: Erstens dürfen keine Personen zu Schaden kommen. Dies wird dadurch erzielt, dass die Module in einem Raum untergebracht sind, welcher im Betriebszustand nicht betreten werden darf.

Zweitens sollen Folgeschäden an Objekten, insbesondere an benachbarten Modulen und Stromschienen, verhindert werden. Diese Auflage wird im allgemeinen kaum zufriedenstellend erfüllt.

Aus DE-A-30'32'133 bekannt ist ein Hochleistungs-Halbleitermodul mit einem Halbleiterelement, zwei Elektroden, zwischen denen das Halbleiterelement verspannt ist, und einem Isoliergehäuse, welches das Halbleiterelement umschliesst. Dieses Modul weist ein Explosionsschutzelement in der Form eines ein- oder mehrteiligen Hohlzylinders aus einem weichen, elastischen Silikongummi auf, welcher in das aus Keramik gefertigte Isoliergehäuse so eingesetzt ist, dass er das Halbleiterelement umschliesst. Geschmolzenes Metall, welches bei einer Explosion weggeschleudert wird, soll durch das Explosionsschutzelement aufgefangen und seine kinetische Energie möglichst absorbiert werden, um das Keramik-Gehäuse und andere benachbarte Elemente des Moduls vor einer Beaufschlagung mit heissem Metall zu schützen. Um dies zu gewährleisten, muss das Explosionsschutzelement eine grosse Absorptionsfähigkeit der kinetischen Energie aufweisen und ferner wärmebeständig sein, damit es nicht bereits vor der Explosion schmilzt.
Nachteilig an dieser Konstruktion erscheint, dass das ursprüngliche Modul durch den Platzbedarf des Schutzelementes vergrössert wird. Zudem lässt es sich nicht in Kombination mit beliebigen Gehäuseformen einsetzen. Ferner wird sich die kinetische Energie nicht in jedem Fall vollständig absorbieren lassen, so dass Stösse durch das Schutzelement auf das Isoliergehäuse übertragen werden. Verfügt das Halbleitermodul über ein Keramik-Gehäuse, wie es in dieser Druckschrift offenbart ist, so mag dank der eigenen Robustheit des Isoliergehäuses der Explosionsschutz genügen. Ist jedoch das Isoliergehäuse aus Kunststoff gefertigt, so können Restenergien durchaus zur Zerstörung des Isoliergehäuses und zur Bildung von neuen Wurfgeschossen führen.

DE-C-26'61'120 offenbart ebenfalls ein Explosionsschutzelement, welches jedoch ausserhalb eines Modulgehäuses angeordnet ist. Das Explosionsschutzelement umgibt das Gehäuse beabstandet in radialer Richtung, wodurch ein Hohlraum gebildet wird, welcher im Falle einer Explosion der Druckabsenkung dienen soll. Hierzu muss der Hohlraum wesentlich grösser sein als der vom Gehäuse umschlossene Raum. Nachteilig an diesem Aufbau ist wiederum der erhöhte Platzbedarf.

### DARSTELLUNG DER ERFINDUNG

Es ist deshalb Aufgabe der vorliegenden Erfindung, ein Hochleistungs-Halbleitermodul mit einem Explosionsschutzelement zu schaffen, welches einen relativ geringen Platzbedarf aufweist und auch bei Gehäusen aus Kunststoff einen genügenden Schutz bei Explosionen bietet.

Diese Aufgabe löst ein Hochleistungs-Halbleitermodul mit den Merkmalen des Patentanspruches 1.

Erfindungsgemäss verfügt das Hochleistungs-Halbleitermodul über eine vorzugsweise dehnbare oder elastische Schutzhülle, welche ausserhalb des Gehäuses angeordnet ist und weggeschleuderte Fragmente dank ihrer Zugfestigkeit auffängt und deren kinetische Energie absorbiert. Dadurch lassen sich sämtliche allfälligen Geschosse, auch allfällige Fragmente des Gehäuses selber, auffangen. Die Schutzhülle, da sie aus einem dehnbaren Material gefertigt ist, lässt sich auf einfache Art und Weise über das Gehäuse stülpen, so dass Produktionszeiten nicht wesentlich tangiert werden. Der Platzbedarf der Schutzhülle ist minimal, so dass eine spezifische Anpassung des Moduldesigns, insbesondere seiner Grösse, an die Schutzhülle nicht notwendig ist. Ein weiterer Vorteil ist, dass sich im Schadensfall sofort klar erkennen lässt, welches Modul zerstört worden ist, da nicht ein aussen noch intaktes Gehäuse eine inexistente Funktionsfähigkeit vorspiegelt.
Da sich die Schutzhülle ausserhalb des Gehäuses und somit vom Halbleiterelement getrennt befindet, muss sie geringeren Materialanforderungen genügen als das aus DE-A-30'32'133 bekannte Schutzelement. Wärmebeständigkeit beispielsweise ist keine zwingende Forderung.

Weitere vorteilhafte Ausgestaltungsformen gehen aus den abhängigen Patentansprüchen hervor.

### KURZE ERLÄUTERUNG DER FIGUREN

In den Zeichnungen sind bevorzugte Ausführungsbeispiele des Erfindungsgegenstandes dargestellt, welche in der nachfolgenden Beschreibung erläutert sind. Es zeigen:
- Figur 1: eine perspektivische Darstellung einer ersten Ausführungsform eines Hochleistungs-Halbleitermoduls mit dem erfindungsgemässen Explosionsschutz;
- Figur 2: eine perspektivische Darstellung einer zweiten Ausführungsform und
- Figur 3: eine perspektivische Darstellung einer dritten Ausführungsform.

### WEGE ZUR AUSFÜHRUNG DER ERFINDUNG

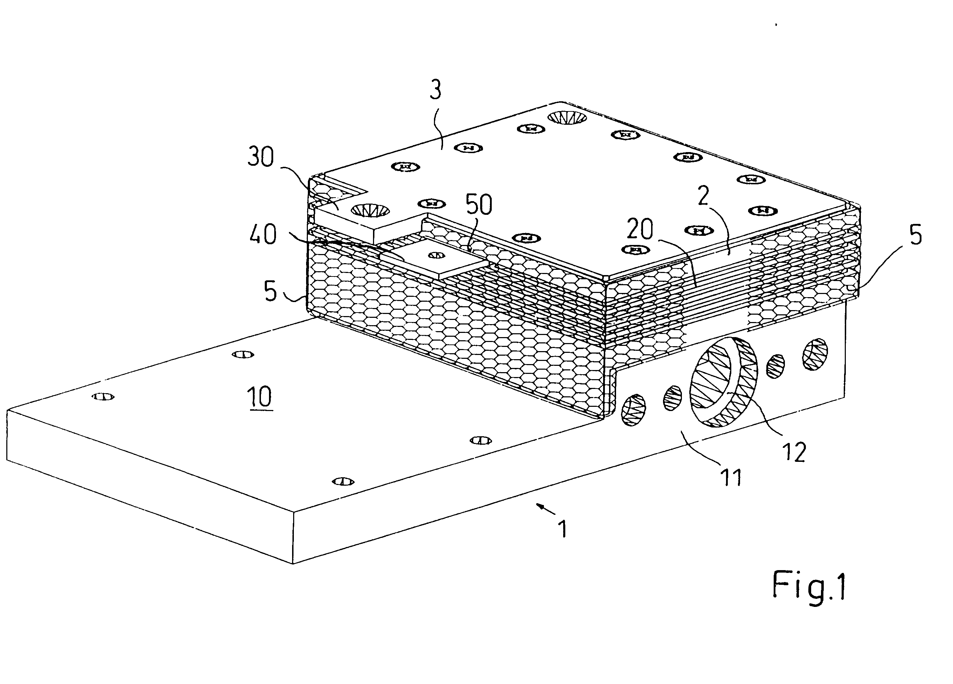

In Figur 1 ist eine erste Ausführungsform eines Hochleistungs-Halbleitermoduls dargestellt, welches mit einem erfindungsgemässen Explosionsschutzelement versehen ist. Es weist im wesentlichen den Aufbau des bekannten stapelbaren "Press Pack" IGBT-Moduls (Insulated Gate Bipolar Transistor) der Anmelderin auf. Das Hochleistungs-Halbleitermodul gemäss der Erfindung beschränkt sich jedoch nicht auf diese Form, sondern es lassen sich beliebige Gehäuseformen von Hochleistungs-Halbleitermodule mit einem Explosionsschutzelement nach der erfindungsgemässen Lehre versehen.

Das dargestellte Hochleistungs-Halbleitermodul weist eine erste Elektrodenplatte in Form eines metallenen Trägerblockes 1, auch Substrat genannt, auf. Dieser Trägerblock 1 ist gestuft ausgebildet, wobei eine tiefe Stufe 10 in eine hohe Stufe 11 übergeht. Die tiefe Stufe 10 schafft Platz für eine hier nicht dargestellte Steuerelektronik. Die hohe Stufe 11 ist mit Bohrungen 12 für Kühlwasseranschlüsse versehen. Auf dieser hohen Stufe 11 ist, in den Zeichnungen nicht sichtbar, mindestens ein Halbleiterelement sowie weitere für die Funktionsfähigkeit des Hochleistungs-Halbleitermoduls notwendigen Bauteile angeordnet. Das Halbeleiterelement ist von einem rechteckförmigen Gehäuse 2, genauer einem Isoliergehäuse, aus Kunststoff umgeben, welches im mittleren Bereich umlaufende Rippen 20 aufweist und im übrigen eine glatte Oberfläche aufweist. Das Gehäuse 2 ist auf der hohen Stufe 11 diese formschlüssig umlaufend aufgesetzt, wobei es im Uebergangsbereich der zwei Stufen 10,11 tiefgezogen ist.

Das Gehäuse 2 ist an seiner oberen, dem Trägerblock 1 abgewandten Oeffnung mit einer verschraubbaren Abdeckplatte 3 aus Metall geschlossen, welche formschlüssig in die Oeffnung passt. Diese Abdeckplatte 3 dient als zweite Elektrodenplatte, wobei eine in Richtung niedrige Stufe 10 vorstehende erste Nase als Kathodenanschluss 30 dient. Ferner ist das Gehäuse 2 von einer zweiten Nase durchsetzt, welche einen Gateanschluss 40 bildet.

Erfindungsgemäss ist das Halbleitermodul von einer Schutzhülle 5 umgeben, wobei es in diesem Beispiel lediglich das Gehäuse 2 umgibt. In Figur 1 ist die Schutzhülle 5 nicht durchgehend gezeichnet, damit das darunter liegende Gehäuse 2 sichtbar bleibt. Die Schutzhülle 5 besteht aus einem Material mit hoher Zugfestigkeit, damit sie durch den Aufprall von weggeschleuderten Fragmenten nicht zerstört wird. Sie ist dehnbar ausgebildet und aus einem Gewebe gefertigt. Einsetzbar sind beispielsweise Kevlar oder andere Materialien, welche für die Fertigung von kugelsicheren Westen eingesetzt werden. In der Figur 1 ist die Schutzhülle 5 grobmaschig dargestellt, dies dient jedoch lediglich der besseren Lesbarkeit der Zeichnung. Vorzugsweise ist das Gewebe der Schutzhülle 5 so dicht, dass auch kleine Splitter nicht durch die Maschen hindurchdringen können.

Die Befestigung der Schutzhülle 5 am Modul lässt sich auf die unterschiedlichste Art und Weise gestalten und hängt insbesondere von der Form des Moduls ab. Im hier dargestellten Beispiel liegt die Schutzhülle 5 am Gehäuse 2 an, wobei es leicht gedehnt ist und somit lediglich durch ihre Elastizität und ohne weitere Befestigungshilfen in ihrer Lage gehalten ist. Dabei lässt sich die Schutzhülle 5 einerseits durch einfaches Ueberstülpen montieren oder indem es bandförmig um das Gehäuse 2 gelegt und anschliessend stoff- oder kraftschlüssig zu einem Ring geschlossen wird. Vorzugsweise ist die Schutzhülle 5 schlauchartig und einstückig ausgebildet, wobei gegebenenfalls Oeffnungen 50 für einzelne Elemente des Moduls vorhanden sind, beispielsweise für den Gateanschluss 40. Mehrstückige Varianten und/oder andere Formen sind jedoch auch einsetzbar.

In anderen, hier nicht dargestellten Ausführungsformen sind Befestigungsmittel vorhanden, welche die Schutzhülle am Modul befestigen. In einer Ausführungsform ist die Schutzhülle am Trägerblock und/oder an der Abdeckplatte befestigt, so dass sie eine mindestens um das Gehäuse umlaufende Hülle bildet. Dadurch wird verhindert, dass Fragmente in Form von Querschlägern aus der Schutzhülle austreten können. In einer weiteren Ausführungsform umgibt die Schutzhülle auch die Elektrodenplatten mindestens teilweise.

Im hier dargestellten Beispiel ist die Schutzhülle anliegend am Gehäuse angeordnet. Gerade bei Verwendung von Befestigungsmitteln ist es je nach Anwendungsbereich jedoch vorteilhaft, einen Freiraum zu belassen und die Schutzhülle beabstandet zum Gehäuse anzuordnen.

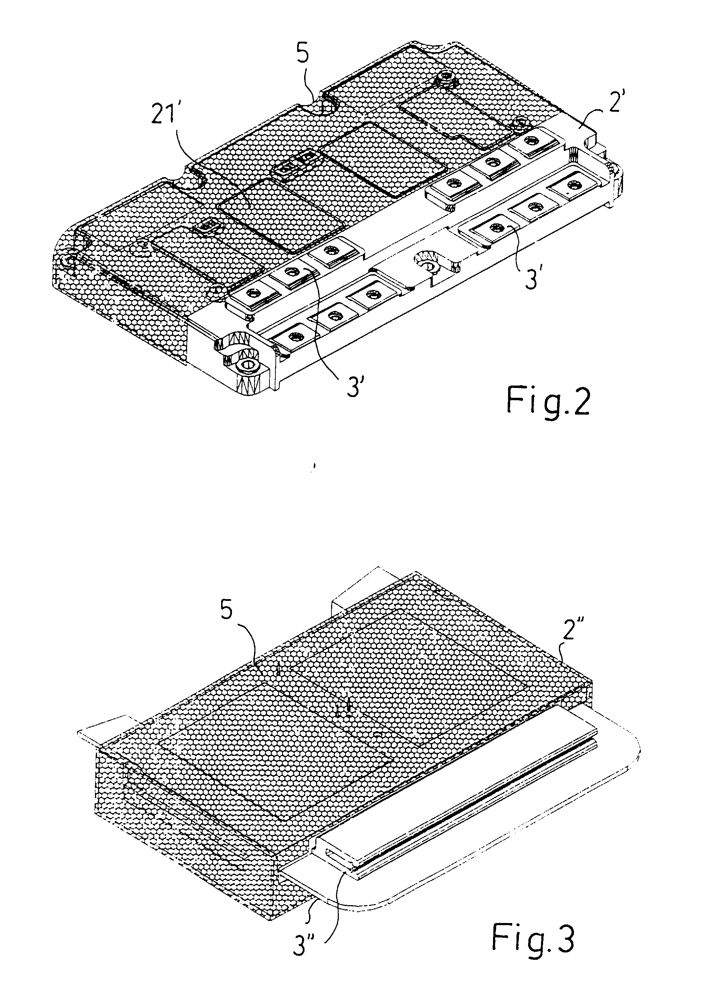

In Figur 2 ist eine zweite Ausführungsform eines an sich bekannten Halbleitermoduls dargestellt, welches mit einem erfindungsgemässen Explosionsschutzelement versehen ist. Es besteht aus mehreren Submodulen mit Halbleiterelementen, welche auf einer gemeinsamen, hier nicht sichtbaren Bodenplatte angeordnet sind. Auf oder über diese Bodenplatte ist ein Gehäuse 2' aus Kunststoff oder einem anderen geeigneten Material aufgesetzt. Das Gehäuse 2' weist mindestens ein, vorzugsweise mehrere Fenster 21' auf, welche bei der Fertigung den Zugang zu den Submodulen ermöglichen und welche anschliessend vorzugsweise mit einer Vergussmasse ausgefüllt werden. Aus dem Gehäuse 2' ragen Anschlüsse 3' heraus zur Erstellung von elektrischen Verbindungen.

Wie in Figur 2 sichtbar ist, ist das Gehäuse 2' und die Bodenplatte teilweise von einer Schutzhülle 5 der oben beschriebenen Art umgeben, wobei der Bereich der Anschlüsse nicht tangiert wird. Es wäre auch möglich, das gesamte Gehäuse inklusive Bodenplatte mit einer derartigen Schutzhülle 5 zu umgeben und wiederum Ausnehmungen für die Anschlüsse freizulassen oder nachträglich zu schaffen. Bei diesem speziellen Modul hat es sich jedoch gezeigt, dass mindestens die Fenster 21' von der Schutzhülle 5 überdeckt sein sollten, um einen effizienten Explosionsschutz zu gewährleisten.

In Figur 3 ist eine dritte Ausführungsform eines an sich bekannten Halbleitermoduls dargestellt. In diesem Fall ist das gesamte Modul von einem Gehäuse 2", vorgzugsweise aus Kunststoff, umgeben, wobei Anschlüsse 3" aus seitlichen Stirnflächen aus dem Gehäuse herausragen. Das gesamte Gehäuse 2'' ist mit einer Schutzhülle 5 der oben beschriebenen Art umgeben, wobei auch in diesem Fall die Schutzhülle 5 vorzugsweise elastisch anliegt. Lediglich die Anschlüsse 3" sowie andere vorstehende Teile sind von der Schutzhülle 5 freigegeben.

In den hier dargestellten Ausführungsformen ist jeweils jedes Modul mit einer eigenen Schutzhülle versehen. Im Falle von stapelbaren Hochleistungs-Halbleitermodulen, insbesondere von sogenannten Hockey-Puck-Modulen mit rundem Querschnitt, lässt sich jedoch eine einzige Schutzhülle für mehrere Module verwenden, indem die Schutzhülle über die übereinandergestapelten Module gestülpt ist.

### BEZEICHNUNGSLISTE

- 1: Trägerblock
- 10: tiefe Stufe
- 11: hohe Stufe
- 12: Bohrungen für Kühlwasseranschlüsse
- 2: Gehäuse
- 20: Rippen
- 2': Gehäuse
- 21': Fenster
- 2": Gehäuse
- 3: Abdeckplatte
- 30: Kathodenanschluss
- 3': Anschlüsse
- 3": Anschlüsse
- 40: Gateanschluss
- 5: Schutzhülle
- 50: Oeffnungen

## Patentansprüche

1. Hochleistungs-Halbleitermodul mit einem Gehäuse (2,2',2"), welches mindestens ein Halbleiterelement umgibt, und einem Explosionsschutzelement zum Schutz vor bei einer Explosion des Moduls weggeschleuderten Fragmente,
dadurch gekennzeichnet, dass
das Explosionsschutzelement eine Fragmente auffangende Schutzhülle (5) ist, welche mindestens einen Teil des Gehäuses (2,2',2'') umgibt und aus einem dehnbaren Material gefertigt ist.

2. Hochleistungs-Halbleitermodul nach Anspruch 1, dadurch gekennzeichnet, dass die Schutzhülle (5) aus Gewebe gefertigt ist.

3. Hochleistungs-Halbleitermodul nach Anspruch 1, dadurch gekennzeichnet, dass die Schutzhülle (5) am Gehäuse (2,2',2") elastisch anliegt.

4. Hochleistungs-Halbleitermodul nach Anspruch 1, dadurch gekennzeichnet, dass das Gehäuse (2,2',2") zwischen zwei Elektrodenplatten (1,3) angeordnet ist, wobei die Schutzhülle (5) an mindestens einer dieser Elektrodenplatten (1,3) befestigt ist.

5. Hochleistungs-Halbleitermodul nach Anspruch 4, dadurch gekennzeichnet, dass die Schutzhülle (5) das Gehäuse (2,2',2") beabstandet umgibt.

6. Hochleistungs-Halbleitermodul nach Anspruch 1, dadurch gekennzeichnet, dass die Schutzhülle (5) einstückig ausgebildet ist.

7. Hochleistungs-Halbleitermodul nach Anspruch 1, dadurch gekennzeichnet, dass die Schutzhülle (5) schlauchförmig ausgebildet ist.

8. Hochleistungs-Halbleitermodul nach Anspruch 1, dadurch gekennzeichnet, dass die Schutzhülle (5) aus Kevlar gefertigt ist.

9. Hochleistungs-Halbleitermodule nach Anspruch 1, dadurch gekennzeichnet, dass mehrere übereinandergestapelte Module von einer gemeinsamen Schutzhülle (5) umgeben sind.
